# FASCICULE DE BREVET EUROPEEN

(11) **EP 3 090 308 B1**
(45) Date de publication et mention de la délivrance du brevet: **02.08.2023**
(21) Numéro de dépôt: 14830999.0
(22) Date de dépôt: 22.12.2014
(51) Int. Cl.: G02C 13/00

(54) **PROCEDE D'AJUSTAGE D'UNE MONTURE DE LUNETTES RÉELLE PREDETERMINEE POUR SON UTILISATION PAR UN PORTEUR DONNE**
ANPASSUNGSVERFAHREN VON EINER VORSELEKTIERTEN REALEN BRILLENRAHMEN ZUR NUTZUNG VON EINEM GEGEBENEN BRILLENTRÄGER
ADJUSTMENT PROCESS OF A PRE-SELECTED REAL SPECTACLES FRAME FOR USE BY A GIVEN WEARER

(30) Priorité: 02.01.2014 FR 1450017
(43) Date de publication de la demande: 09.11.2016
(73) Titulaire: Essilor International, 94220 Charenton-le-Pont (FR)
(72) Inventeur: HADDADI, Ahmed, 94220 Charenton-Le-Pont (FR); MARIE, Sarah, 94220 Charenton-Le-Pont (FR)
(74) Mandataire: Jacobacci Coralis Harle
(86) Numéro de dépôt international: PCT/FR2014/053505
(87) Numéro de publication internationale: WO 2015/101738

(56) Documents cités:
- EP-A1- 1 011 006
- WO-A1-01/79918
- WO-A1-2013/149891
- GB-A- 358 838
- US-A- 4 762 407
- US-A1- 2003 123 026

## Description

### DOMAINE TECHNIQUE AUQUEL SE RAPPORTE L'INVENTION

La présente invention concerne un procédé d'ajusage d'une monture de lunette prédéternimée pour son utilisation par un porteur donné.

### ARRIERE-PLAN TECHNOLOGIQUE

Habituellement, l'opticien effectue l'ajustage de la monture directement sur le visage du porteur, manuellement, en fonction des indications de confort que lui fournit le porteur et selon un savoir-faire empirique.

Cet ajustage est long et fastidieux pour l'opticien et le porteur, et sa qualité, importante pour la correction visuelle, dépend de l'opérateur et du soin accordé à cette opération.

Il est souvent réalisé à la réception de la paire de lunettes finie, c'est-à-dire dans laquelle les lentilles ophtalmique ont été montées.

Ce processus ne permet donc pas toujours la réalisation de paires de lunettes dont les caractéristiques optiques et mécaniques sont précisément adaptées au porteur.

On connaît notamment du document US4762407 un procédé de détermination des caractéristiques d'une monture de manière à ce qu'elle soit parfaitement adaptée au visage du porteur, qui constitue une réponse possible à ce problème.

Dans le procédé proposé par ce document, le placement idéal devant les yeux du porteur des lentilles ophtalmiques adaptées à la correction visuelle du porteur est tout d'abord déterminé. Puis les caractéristiques géométriques de la monture permettant ce placement idéal des lentilles ophtalmiques devant les yeux du porteur sont déterminées en fonction de la forme du visage du porteur. La monture est enfin construite de manière à présenter les caractéristiques géométriques déterminées.

Ce procédé ne permet cependant pas d'ajuster une monture prédéterminée, déjà assemblée, sur le visage d'un porteur, en l'absence ou en présence de lentilles ophtalmiques. On connaît également du document EP1011006 un procédé de fabrication d'une monture de lunettes permettant de choisir les éléments constituant la monture en fonction des préférences du porteur. On connait enfin du document US2003/123026 une méthode d'essayage virtuel de montures de lunettes.

### OBJET DE L'INVENTION

Afin de remédier à l'inconvénient précité de l'état de la technique, la présente invention propose un procédé permettant d'effectuer un ajustage d'une monture de lunettes réelle pré-existante sur le visage du porteur.

Plus particulièrement, on propose selon l'invention un procédé d'ajustage d'une monture de lunettes réelle prédéterminée et choisie par le porteur, pour son utilisation par ce porteur donné, conforme à la revendication 1.

Ainsi, grâce au procédé selon l'invention, il est possible de déterminer la déformation nécessaire de la monture de lunette réelle choisie par le porteur et présentant une géométrie prédéterminée afin de l'ajuster sur la tête du porteur de manière à ce que cette monture de lunettes soit correctement positionnée sur son visage et de renvoyer une information sur l'adéquation entre la capacité à se déformer de la monture et la déformation nécessaire de la monture déterminée.

On entend par « correctement positionnée » le fait que la monture repose de manière stable et confortable sur le visage du porteur.

On considère ainsi que la monture de lunettes est correctement positionnée sur le visage du porteur lorsque les conditions suivantes sont satisfaites simultanément :
- les cercles de la monture sont positionnés par rapport aux yeux du porteur de manière à offrir un champ de vision le plus étendu possible au porteur,
- la monture de lunettes repose sur le nez, sans glisser et sans blesser, avec toute la stabilité nécessaire,
- les branches de la monture de lunettes reposent sur les oreilles du porteur, sans compression exagérée sur les tempes, sans traction trop forte sur les oreilles.

Une fois cette déformation nécessaire déterminée, il est possible de l'appliquer à la monture de lunettes. Ceci est réalisé de préférence avant le montage des lentilles ophtalmiques dans la monture.

On envisage ici seulement de déformer la monture réelle sans ajout de matière et en restant dans les limites de déformation élastique des matériaux, de manière à obtenir la monture personnalisée souhaitée sans l'endommager.

La déformation de la monture réelle prédéterminée est ainsi réalisable sans endommager et/ou sans casser cette monture.

Ce procédé peut tout d'abord être mis en oeuvre avant la fabrication des lentilles ophtalmiques destinées à être montées dans la monture.

Le procédé permet alors notamment d'ajuster la monture au visage du porteur afin de prendre les mesures nécessaires à la fabrication des lentilles ophtalmiques sur le porteur portant la monture de lunettes ajustée.

La fabrication des lentilles ophtalmiques est alors plus précise.

Une fois les lentilles ophtalmiques fabriquées et montées dans la monture de lunettes, il est possible que le poids des lentilles ophtalmiques déforme la monture de lunettes et que celle-ci ne présente plus exactement la géométrie ajustée avant le montage des lentilles ophtalmique. Il est alors possible de déterminer la déformation de la monture nécessaire pour ajuster la monture munie des lentilles ophtalmique sur le visage du porteur. On parle alors de réajustage de la monture.

D'autres caractéristiques non limitatives et avantageuses du procédé conforme à l'invention sont décrites dans les revendications 2 à 10.

Selon encore d'autres caractéristiques :
- à l'étape d), ledit critère d'ajustage prédéterminé comprend une inclinaison des branches de la monture souhaitée ;
- dans une étape e), on fournit à l'utilisateur des instructions d'ajustage pour appliquer à la monture de lunettes la déformation déterminée à l'étape d) ;
- dans une étape f), on applique à la monture de lunettes la déformation déterminée à l'étape d) ;
- on réalise en outre l'étape suivante :
   g) on détermine la position relative corrigée du modèle d'une partie des cercles de la monture et du modèle d'une partie des yeux du porteur en prenant en compte la déformation nécessaire de la monture déterminée à l'étape d), au moyen d'une simulation numérique analogue à celle de l'étape c).
- on réalise en outre l'étape suivante :
   h) on détermine au moins un paramètre géométrico-physionomique d'implantation d'une lentille ophtalmique dans la monture pour que le centre optique de la lentille vienne en regard de l'œil correspondant du porteur, en fonction de ladite position relative corrigée déterminée à l'étape g).
- on réalise en outre l'étape suivante :
   i) on détermine au moins une caractéristique de réfraction optique d'au moins une lentille ophtalmique à monter dans cette monture en fonction de ladite position relative corrigée déterminée à l'étape g) ;
- l'étape b) est réalisée sur un premier site et l'étape d) est réalisée sur un deuxième site ;
- le premier site est localisé dans un lieu quelconque accessible soit physiquement par le porteur, soit sur internet, et le deuxième site est situé chez un opticien ou dans un laboratoire de montage de lunettes.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue schématique en perspective d'une monture de lunettes (traits pleins) et d'une modélisation partielle de la tête du porteur (traits pointillés),
- la figure 2 est une vue schématique de dessus de la monture de lunettes et de la modélisation partielle de la tête de la figure 1,
- la figure 3 est une vue schématique de profil de la tête du porteur avec la monture de lunettes,
- la figure 4 est une vue schématique de face de la tête du porteur et de la monture de lunettes de la figure 3,
- les figures 5 et 6 illustrent un ajustage correct d'une branche de la monture de lunettes sur l'oreille du porteur.

Le procédé objet de l'invention a pour objectif de permettre un ajustage précis et aisé de la monture sur la tête du porteur, en minimisant l'intervention de l'opticien et du porteur.

Ceci permet d'une part, de limiter le temps passé par l'opticien à ajuster les montures, et d'autre part, à rendre le processus d'ajustage moins fastidieux pour le porteur.

En outre, le procédé objet de l'invention a pour but de permettre un ajustage « à distance » virtuel, c'est-à-dire sans la présence physique du porteur et/ou de la monture de lunettes réelle, par la détermination de la déformation nécessaire de la monture pour réaliser un ajustage précis. Cette déformation peut ensuite être appliquée à la monture, soit automatiquement par une machine, soit manuellement par une personne qualifiée, qui n'est pas forcément l'opticien, en présence ou en l'absence du porteur. L'ajustage réel de la monture est ainsi réalisé.

Il s'agit ici d'une déformation sans ajout de matière et en restant dans les limites de déformation élastique des matériaux constituant la monture.

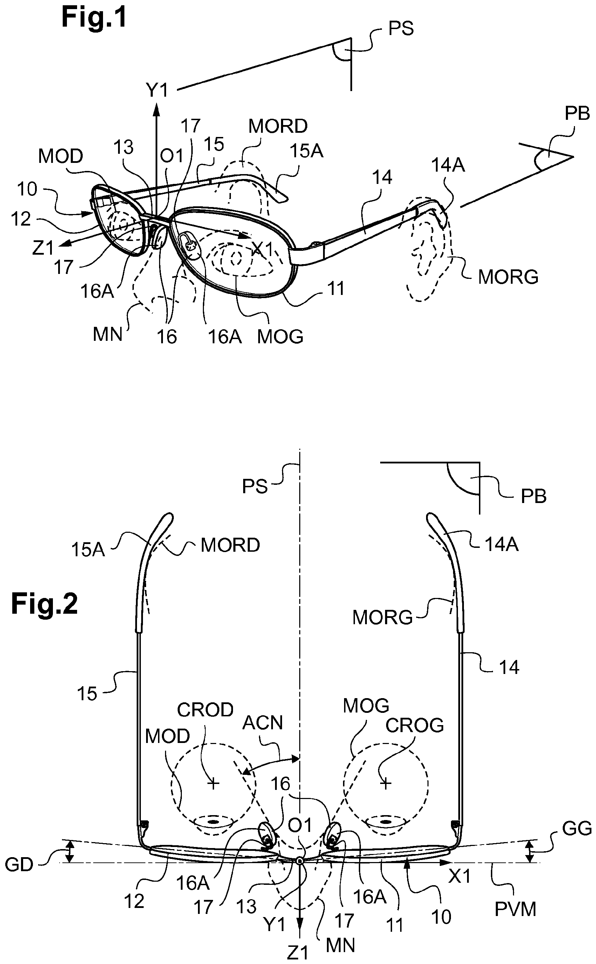

Sur les figures 1 à 4, on a représenté une monture 10 de lunettes réelle prédéterminée, choisie par le porteur. Dans l'exemple illustré, la monture de lunettes est de type cerclé, c'est-à-dire que la monture 10 comporte des cercles 11, 12 dans lesquels les lentilles ophtalmiques sont adaptées à être montées.

Ces deux cercles 11, 12 sont reliés de manière rigide par un pont nasal 13. Chaque cercle 11, 12 est également relié à une branche 14, 15, habituellement articulée sur le cercle correspondant.

On considérera dans la suite que les branches sont fixes, dans leur position ouverte l'une par rapport à l'autre.

Le pont nasal 13 comporte deux surfaces d'appui 16 sur les ailes du nez du porteur (figure 1). Ces surfaces d'appui 16 peuvent être fixes, par exemple dans le cas d'une monture en plastique dans laquelle ces surfaces sont intégrées aux cercles de la monture, ou être réglables, par exemple dans le cas d'une monture métallique dans laquelle il est prévu deux plaquettes 16A chacune reliée au pont nasal par un bras 17 (figures 1 et 2).

C'est ce dernier cas qui est représenté sur les figures.

Les plaquettes 16A portant les surfaces d'appui 16 de la monture 10 sur le nez du porteur présentent principalement deux paramètres réglables : d'une part la distance de la plaquette 16A au cercle 11, 12 de la monture 10 et d'autre part l'inclinaison de la plaquette 16A suivant un angle de face et un angle de chasse définis ultérieurement.

Dans le cas des montures plastiques décrit précédemment, la position et l'inclinaison des surfaces d'appui de la monture sur le nez du porteur sont prédéterminées et fixes.

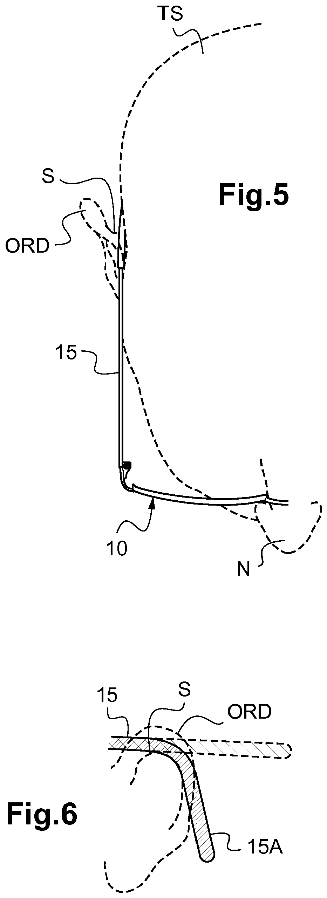

Chaque branche 14, 15 de la monture 10 comprend au moins une première partie dont l'extrémité est reliée au cercle 11, 12 correspondant. Cette première partie peut être droite (figure 5) ou présenter une légère courbure lui permettant d'épouser le contour de la tête TS du porteur.

Sur l'exemple représenté sur les figures, chaque branche 14, 15 de la monture 10 comporte en outre une deuxième partie sous la forme d'une spatule 14A, 15A prolongeant la première partie de la branche 14, 15 à l'extrémité opposée aux cercles 11, 12 de la monture 10.

Cette spatule 14A, 15A forme l'extrémité recourbée de la branche 14, 15 correspondante. Elle est destinée à venir se placer derrière l'oreille ORD, ORG correspondante du porteur (voir figure 6).

En variante, les branches de la monture ne comportent pas de spatules. Dans ce cas, c'est l'extrémité libre de la première partie de la branche qui repose sur l'oreille du porteur. Cette variante est représentée en pointillé sur la figure 6.

En variante encore, la monture de lunettes peut être de type percé, c'est-à-dire que les lentilles sont percées et maintenues chacune par une extrémité du pont nasal et une extrémité de la branche associée à la lentille, qui coopèrent avec des trous de perçage. Ce type de monture est similaire à celui décrit précédemment, sauf qu'il ne comporte pas de cercles. Le pont nasal et les branches sont similaires. Dans ce cas, on prend en compte pour la mise en oeuvre du procédé d'ajustage décrit plus loin le contour des lentilles ophtalmique destinées à être montées dans la monture à la place des cercles de la monture.

De manière générale, les montures neuves, en sortie d'usine, présentent un plan de symétrie PS passant par le milieu du pont nasal 13 et équidistant des branches 14, 15 de la monture 10.

En outre, la première partie des deux branches 14, 15 s'étend initialement un même plan moyen PB.

Comme représenté sur les figures 1 et 2, on définit un premier référentiel associé à la monture 10, c'est-à-dire dans lequel la monture 10 présente une position et une orientation fixe, ayant un repère orthonormé (O1, X1, Y1, Z1). Le centre O1 du repère de ce premier référentiel est, par exemple, le milieu du pont nasal 13. L'axe O1Z1 est parallèle à l'intersection du plan de symétrie PS de la monture 10 et du plan moyen PB des branches 14, 15. L'axe O1Y1 s'étend dans le plan de symétrie PS de la monture 10, dans la direction opposée aux cercles de la monture. L'axe O1X1 s'étend parallèlement au plan moyen des branches PB. Le plan O1Y1Z1 correspond alors au plan de symétrie PS de la monture 10. Le plan O1X1Z1 est parallèle au plan moyen des branches PB. Le plan O1X1Y1 est appelé plan vertical monture PVM.

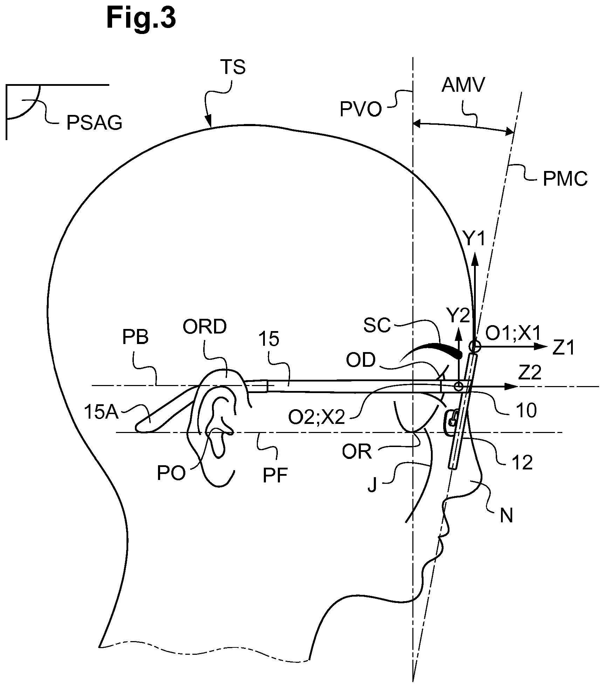

Comme représenté sur la figure 3, on définit un deuxième référentiel associé à la tête TS du porteur, c'est-à-dire dans lequel la tête TS du porteur présente une position et une orientation fixe, ayant un repère orthonormé (O2, X2, Y2, Z2).

Le plan de Francfort PF de la tête TS du porteur est défini comme le plan passant par les points orbitaires inférieurs OR et le porion PO du porteur, le porion étant le point du crâne le plus élevé du conduit auditif, qui correspond au tragion de l'oreille.

On considère que le porteur est dans une position orthostatique, position dans laquelle il réalise un minimum d'efforts. L'axe de regard du porteur est l'axe de regard primaire, c'est-à-dire qu'il regarde droit devant lui. Le plan de Francfort PF est alors horizontal.

On définit un plan sagittal PSAG de la tête TS du porteur comme étant le plan vertical passant par la médiatrice AO des deux yeux OG, OD. La médiatrice AO des yeux est l'axe passant au milieu du segment défini par les centres de rotation des deux yeux et parallèle au plan de Francfort PF.

Le centre O2 du repère de ce deuxième référentiel est, par exemple, le milieu du segment reliant les centres de rotation des yeux OD, OG du porteur.

L'axe O2Z2 est situé dans le plan sagittal PSAG de la tête TS du porteur et est parallèle au plan de Francfort PF. Il s'étend dans une direction s'éloignant de la tête du porteur. L'axe O2Y2 s'étend dans le plan sagittal PSAG de la tête TS du porteur et est perpendiculaire au plan de Francfort PF. L'axe O2X2 s'étend parallèlement au plan de Francfort PF. En variante, tout autre référentiel de la monture et/ou de la tête du porteur peut être envisagé.

Dans l'exemple décrit ici, le procédé d'ajustage est d'abord mis en oeuvre avant la fabrication des lentilles ophtalmiques destinées à être montées dans la monture.

La monture 10 peut alors comprendre des lentilles de présentation non correctrices ou aucune lentille.

Selon le procédé d'ajustage de la monture 10 de lunettes réelle prédéterminée conforme à l'invention, on réalise les étapes suivantes :
b) on détermine une modélisation au moins partielle de la tête TS du porteur, avec, dans un même référentiel, au moins un modèle MN d'une partie du nez N, un modèle MORD, MORG d'une partie des oreilles ORD, ORG,
c) on effectue une simulation du positionnement de la monture 10 réelle sur la tête TS du porteur, en superposant, sur la modélisation de la tête TS du porteur, les zones correspondantes de ladite monture 10 réelle ou d'une modélisation de celle-ci,
d) on détermine, à partir de cette superposition, la déformation nécessaire de la monture 10 pour obtenir un ajustage de la monture 10 réelle prédéterminée sur la tête TS du porteur conforme à au moins un critère d'ajustage prédéterminé,
p) on renvoie une information sur l'adéquation entre la capacité à se déformer de la monture et la déformation nécessaire de la monture déterminée à l'étape d).

Selon un premier mode de réalisation du procédé selon l'invention, celui-ci est mis en oeuvre par des moyens informatiques et électroniques programmés à cet effet.

Ainsi, à l'étape b), la modélisation de la tête du porteur est une modélisation numérique, et, à l'étape c), on superpose sur cette modélisation numérique de la tête TS du porteur, une modélisation numérique de la monture, par un calcul numérique.

Alors, de préférence, dans une première étape a) du procédé selon l'invention, on détermine une modélisation au moins partielle de la monture 10, avec dans ledit premier référentiel (O1, X1, Y1, Z1), au moins un modèle d'une partie du pont 13 de la monture 10 et un modèle d'une partie des branches 14, 15 de la monture 10.

On détermine en outre de préférence un modèle d'une partie des cercles 11, 12 de la monture 10.

Cette modélisation de la monture 10 (non représentée sur les figures) peut être constituée par exemple d'un ensemble de mesure de longueurs et d'angles caractéristiques de la monture.

Ces mesures comportent par exemple, pour le modèle d'une partie des branches : la longueur de la première partie des branches 14, 15, la longueur des spatules 14A, 15A, l'écart entre les branche 14, 15, l'angle entre la spatule 14A, 15A et la première partie de la branche 14, 15 correspondante dans le plan O1Y1Z1 et dans le plan O1X1Z1.

Elles comportent par exemple, pour le modèle d'une partie du pont : l'écart entre les surfaces d'appui 16 du pont 13 sur le nez, l'angle formé entre des surfaces d'appui 16 et la distance de ces surfaces d'appui aux cercles de la monture 10. Elles comportent par exemple, pour le modèle des cercles 11, 12 : le diamètre de chaque cercle 11, 12 dans le plan O1,X1,Z1, la mesure du galbe GD,GG, correspondant à l'angle formé entre chaque cercle 11, 12 et le plan O1X1Y1 ou plan vertical monture PVM (figure 2), et la position des points les plus hauts et les plus bas des cercles 11, 12 dans le plan O1Y1Z1. A partir de ces mesures de longueurs et d'angle, il est possible de reconstituer une modélisation de la monture 10. Cette reconstitution peut tenir compte d'autres paramètres, tel que le matériau de la monture ou l'épaisseur des branches et des cercles.

La modélisation de la monture 10 (non représentée sur les figures) peut également être constituée par la donnée de la position dans le premier référentiel (O1, X1, Y1, Z1) d'un certain nombre de points particuliers de la monture 10. Cette modélisation peut enfin être le résultat d'une acquisition d'image en trois dimensions de la monture 10. Cette acquisition peut être faite par exemple à l'aide d'un dispositif d'acquisition d'image stéréoscopique ou à l'aide d'un scanner en trois dimensions. Quelle que soit la méthode d'obtention de la modélisation de la monture 10, celle-ci est mise en mémoire dans les moyens informatiques et électroniques précités. Il est ainsi possible de disposer, dans cette mémoire, d'une base de données comportant les modélisations d'un ensemble de montures de lunettes disponibles, qui sont déterminées à l'avance.

Dans une deuxième étape b) du procédé selon l'invention, on détermine une modélisation au moins partielle de la tête TS du porteur, avec, dans ledit deuxième référentiel (O2, X2, Y2, Z2), au moins un modèle MN d'une partie du nez N et un modèle MORD, MORG d'une partie des oreilles ORD, ORG.

On détermine en outre de préférence un modèle MOD, MOG d'une partie des yeux du porteur.

Ces modèles sont représentés schématiquement sur les figures 1 et 2 par des pointillés.

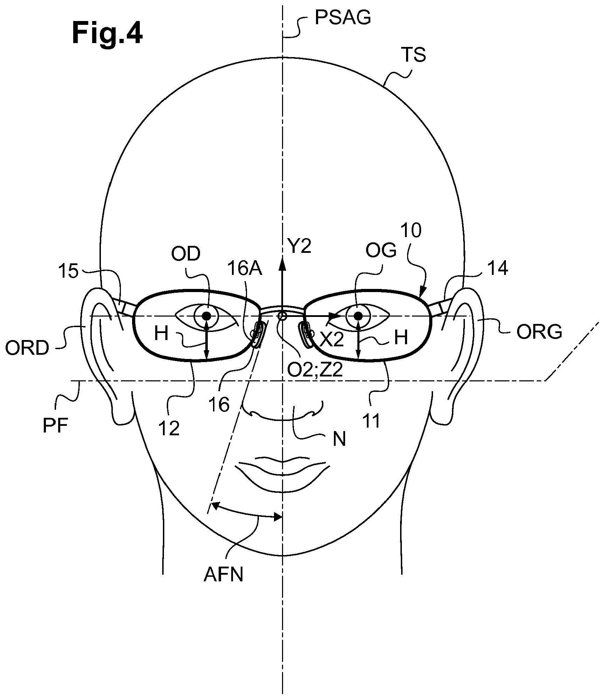

Le modèle MN d'une partie du nez comporte par exemple de préférence la largeur de la racine du nez N, l'angle de face AFN (figure 4) du nez, l'angle de chasse ACN du nez (figure 2).

Le modèle MORD, MORG d'une partie de chaque oreille du porteur comporte les coordonnées d'une surface courbe correspondant au sillon S situé entre le pavillon de l'oreille ORD, ORG et le crâne du porteur, à l'arrière de l'oreille (figures 5 et 6). C'est en effet sur ce sillon S que repose la branche 14, 15 correspondante de la monture 10 de lunettes.

Le modèle MOD, MOG des yeux du porteur comporte par exemple la position dans le deuxième référentiel (O2, X2, Y2, Z2) du centre de rotation CROD, CROG de chaque oeil. Il peut également comprendre un diamètre de l'oeil : le modèle de l'œil est alors constitué d'une sphère de ce diamètre centrée sur le centre de rotation de l'œil (figure 2). On détermine également, de préférence, un modèle d'une partie des pommettes J et/ou des sourcils SC (figure 3) de la tête du porteur. Cette modélisation est de préférence le résultat d'une acquisition d'image en trois dimensions de la tête TS du porteur. Cette acquisition peut être faite par exemple à l'aide d'un dispositif d'acquisition d'image stéréoscopique ou à l'aide d'un scanner en trois dimensions.

L'acquisition d'images en trois dimensions est réalisée de préférence pour la tête TS du porteur de face (figure 4), de profil (figure 3) et le tour des oreilles. Elle est de préférence d'une précision de 2 degrés d'angle et de deux millimètres sur les distances.

Elle peut être réalisée par un opérateur extérieur, par exemple par l'opticien dans son magasin. On peut également envisager qu'elle soit réalisée à distance, par exemple par le porteur lui-même chez lui, puis transmise à l'opérateur chargé de l'ajustage de la monture choisie.

La modélisation de la tête du porteur peut également être réalisée par une capture d'une ou plusieurs images en deux dimensions de la tête du porteur.

Quel que soit le dispositif de capture d'image utilisé, 2D ou 3D, on enregistre en correspondance avec les images capturées une information indiquant l'échelle de l'image capturée. Il peut s'agir de l'image d'un indicateur d'échelle disposé sur la tête du porteur, par exemple un élément comportant un motif de dimensions connues, rapporté sur la tête ou sur une monture de lunettes du porteur ou l'écart inter-pupillaire connu du porteur. Cette information peut également être fournie par le dispositif de capture d'image ou reçue par celui-ci.

Cette modélisation de la tête du porteur est également mise en mémoire dans les moyens informatiques et électroniques.

Les première et deuxième étapes a) et b) du procédé selon l'invention peuvent être réalisées dans n'importe quel ordre, voire même simultanément.

Dans une troisième étape c) du procédé, les moyens informatiques et électroniques effectuent une simulation du positionnement de la monture 10 sur la tête TS du porteur, en superposant, au moins partiellement, d'une part, le modèle d'une partie du pont 13 de la monture 10 et le modèle d'une partie du nez N du porteur, et, d'autre part, le modèle d'une partie des branches 14, 15 de la monture 10 et le modèle d'une partie des oreilles ORD, ORG du porteur.

Il s'agit ici de superposer par calcul la modélisation de la monture 10 et de la modélisation de la tête TS du porteur.

L'exemple qui suit donne une méthode de réalisation possible de la superposition numérique des deux modélisations.

On considère initialement que les premier et deuxième référentiels (O1, X1, Y1, Z1) et (O2, X2, Y2, Z2) de la monture et de la tête sont confondus, puis on optimise leur positionnement relatif, en maintenant l'axe O1X1 parallèle à l'axe O2X2. L'horizontalité de la monture sur la tête du porteur est ainsi assurée.

On déplace ainsi le premier référentiel (O1, X1, Y1, Z1) de la monture en translation dans le plan (02, Y2, Z2), en translation selon l'axe O2X2, et en rotation suivant cet axe O2X2 du deuxième référentiel de la tête.

On appelle DY, DZ les distances de translation du premier référentiel (O1, X1, Y1, Z1) selon O2Y2 et O2Z2 et on appelle DtetaX, l'angle de rotation du premier référentiel (O1, X1, Y1, Z1) de la monture suivant O2X2.

On définit alors une fonction à trois paramètres F(DY, DZ, DtetaX) dont la valeur est minimale quand les valeurs DY, DZ, DtetaX simulent au mieux le positionnement de la modélisation de la monture sur la modélisation de la tête.

Par exemple, la fonction F est minimale quand on maximise la surface de contact entre les plaquettes de la monture et les ailes du nez du porteur, ou lorsque la distance entre les plaquettes de la monture et les ailes du nez est minimale, et lorsque le contact entre les branches de la monture et le haut du sillon S des oreilles du porteur est maximal, ou lorsque la distance entre chaque branche de la monture et le sillon S de l'oreille correspondante est minimale.

Ainsi, la fonction F peut par exemple s'écrire sous la forme suivante : F(DY, DZ, DtetaX) = alpha1.F1(DY, DZ, DtetaX) + alpha2 .F2(DT, DZ, DtetaX), où
- la fonction F1 est une fonction présentant un minimum lorsque le contact entre les plaquettes de la monture et les ailes du nez et
- la fonction F2 est une fonction présentant un minimum lorsque le contact entre les branches et les sillons des oreilles est maximal,
- alpha1 et alpha2 sont des coefficients de pondération, positifs.

Les fonctions Fi représentent les différents critères d'ajustage pris en compte. Ces critères d'ajustage sont détaillés plus loin.

En pratique, le paramètre DY est représentatif d'une hauteur du positionnement du pont de la monture sur le nez, le paramètre DZ est représentatif d'une distance entre les yeux et les cercles de la monture, et le paramètre DtetaX est représentatif d'un angle d'inclinaison des branches de la monture par rapport à l'axe O2Z2 du deuxième référentiel de la tête du porteur. Il est aussi possible de n'optimiser que les paramètres DY, DZ, en considérant que les branches de la monture sont parallèles à l'axe O2Z2 du deuxième référentiel. On alors une fonction F3 de deux paramètres F3(DY,DZ). Selon une autre variante, on peut aussi ajouter des paramètres de positionnement supplémentaires, par exemple une distance de translation selon l'axe O2X2 du deuxième référentiel de la tête, appelée DX, un angle DtetaY de rotation suivant l'axe O2Y2, un angle DtetaZ de rotation suivant l'axe O2Z2 de ce deuxième référentiel. Cela rend l'optimisation plus complexe mais plus précise.

Dans l'exemple développé ci-dessus, les valeurs des paramètres DY, DZ, DtetaX sont recherchées en minimisant la fonction F par des méthodes classiques d'optimisation, par exemple par la méthode du gradient ou la méthode Levenberg-Marquardt.

D'autres fonctions Fi (i>2) peuvent être introduites dans la fonction F d'optimisation avec des facteurs alphai de pondération, pour déterminer plus précisément le positionnement relatif de la modélisation de la monture sur la modélisation de la tête du porteur, par exemple des fonctions permettant de prendre en compte le poids de la monture, le coefficient de friction de la monture sur la peau.

Ces facteurs de pondération peuvent également être déterminés en fonction des souhaits particuliers du porteur. Celui-ci peut souhaiter par exemple un positionnement plus ou moins haut des montures sur le nez du porteur. La monture est en effet souvent positionnée plus bas sur le nez pour une position de lecture.

Les facteurs alpha1, alpha2, alphai de pondération permettent de prendre en compte l'importance relative des différentes fonctions considérées.

Il est par exemple possible de minimiser certains facteurs de pondération afin de permettre un ajustage plus aisé de la monture.

A la fin de l'optimisation, on a ainsi réalisé un positionnement virtuel de la modélisation de la monture sur la modélisation de la tête du porteur, qui est représentatif du positionnement de la monture 10 réelle sur la tête TS du porteur, avant déformation de la monture. Le positionnement n'est donc pas parfait, et peut être encore éloigné du positionnement idéal souhaité.

Une fois la position relative optimale de la modélisation de la monture dans sa géométrie initiale déterminée, on détermine, dans une étape d), à partir de cette superposition, la déformation nécessaire de la monture 10 pour obtenir un ajustage de la monture 10 sur la tête TS du porteur conforme à au moins un critère d'ajustage prédéterminé.

Il s'agit de déterminer la déformation nécessaire de la monture 10 afin de réaliser un ajustage satisfaisant, grâce auquel :
- les cercles de la monture sont positionnés par rapport aux yeux du porteur de manière à offrir, par exemple, un champ de vision le plus étendu possible au porteur, tout en respectant des critères d'esthétisme,
- la monture de lunettes repose sur le nez, sans glisser et sans blesser, avec toute la stabilité nécessaire,
- les branches de la monture de lunettes reposent sur les oreilles du porteur, sans compression exagérée sur les tempes, sans traction trop forte sur les oreilles,
- la monture est horizontale sur la tête du porteur, c'est-à-dire l'axe O1X1 du premier référentiel est parallèle à l'axe O2X2 du deuxième référentiel, ou l'axe O2X2 du deuxième référentiel est parallèle à une ligne associée aux sourcils ou à la droite passant par les deux pupilles du porteur.

Un ajustage satisfaisant des branches 14, 15 de la monture 10 est notamment illustré sur les figures 5 et 6. La figure 5 montre comment la branche 15 de la monture suit le contour de la tête TS du porteur, sans appuyer sur sa tête, et comment la branche 15 repose sur le sillon S de son oreille ORD.

La figure 6 montre comment la cambrure de la branche 15 située à la jonction entre la première partie de la branche 15 et la spatule 15A doit s'adapter à la forme du sillon S de l'oreille ORD.

Les critères d'ajustage permettant de déterminer l'ajustage peuvent notamment comprendre, tout d'abord, des critères d'optimisation identiques à ceux utilisés précédemment, mais utilisés cette fois-ci en tenant compte de la possibilité de déformer la monture:
- maximisation de la surface de contact 16 entre les plaquettes 16A du pont 13 et le nez du porteur,
- maximisation du contact entre les branches 14, 15 de la monture 10 et le sillon S des oreilles ORD, ORG du porteur,
- centrage des yeux OD, OG par rapport aux cercles 11, 12 de la monture 10. Du fait que l'on envisage des déformations possibles de la monture, il est possible de prendre en compte d'autres critères :
- maintien de l'axe O1X1 parallèle à l'axe O2X2 afin de garantir l'horizontalité de la monture 10,
- minimisation des zones de contact entre les cercles 11, 12 de la monture 10 et les pommettes J et/ou les sourcils SC du porteur ;

Il est également possible de prendre en compte des valeurs cibles de différents paramètres d'ajustage de la monture 10 sur la tête du porteur :
- valeur cible de l'écartement des branches 14, 15 de la monture 10 ;
- valeur cible de l'inclinaison des branches 14, 15 de la monture 10 par rapport aux cercles de la monture 10 ;
- valeur cible de l'écart entre les plaquettes 16A,
- valeur cible de l'écart entre les yeux OD, OG et les cercles 11, 12 de la monture 10,
- valeur cible de l'écart entre les cercles de la monture 10 et les sourcils et/ou les pommettes du porteur,
- valeur cible de l'angle pantoscopique AMV (figure 3),
- valeur cible du galbe de la monture.

On définit l'angle pantoscopique AMV comme l'angle entre le plan moyen de chaque cercle PMC de la monture 10 et le plan vertical oeil PVO, qui est le plan perpendiculaire à l'axe du regard en position orthostatique.

De préférence, le plan vertical oeil PVO correspond également au plan perpendiculaire au plan de Francfort passant par les centres de rotation CROG, CROD des yeux, mesuré en projection dans le plan sagittal de la tête TS du porteur.

On peut définir ces valeurs cibles en fonction de valeurs standards d'ajustage : par exemple une valeur cible de la distance entre les yeux et les cercles de la monture, c'est-à-dire entre les sommets cornéens des yeux et le plan moyen de chaque cercle, est égale à 12 millimètres.

On peut également fixer une valeur cible de l'écart entre les cercles de la monture 10 et les sourcils et/ou les pommettes du porteur égale à 3 millimètres, par exemple.

On peut enfin fixer ainsi une valeur cible égale à 6 degrés pour l'angle pantoscopique ou égale à 8 degrés pour la valeur de l'angle de galbe de la monture 10.

Les valeurs cibles peuvent également être déterminées en fonction du matériau de la monture : par exemple, pour un ajustage satisfaisant, on peut prévoir une valeur cible de l'écart entre les branches en fonction de l'écart supérieur auriculaire, c'est-à-dire l'écart entre les sillons S des oreilles droites ORD et gauches ORG.

Pour des branches souples par exemple réalisées en métal et de fine épaisseur, la valeur cible de l'écart entre les branches est égale à l'écart supérieur auriculaire moins quinze millimètres.

Pour des branches semi-rigides, par exemple réalisées en métal et de forte épaisseur, la valeur cible de l'écart entre les branches est égale à l'écart supérieur auriculaire moins dix millimètres.

Pour des branches rigides, par exemple réalisées en plastique et de fine épaisseur, la valeur cible de l'écart entre les branches est égale à l'écart supérieur auriculaire moins cinq millimètres.

Pour des branches très rigides, par exemple réalisée en plastique et de forte épaisseur, la valeur cible de l'écart entre les branches est égale à l'écart supérieur auriculaire moins deux ou trois millimètres.

Les valeurs cibles peuvent être remplacées par des intervalles de valeurs cibles.

On peut également prendre en compte d'autres critères empiriques, par exemple, imposer que la branche 14, 15 se trouve en contact avec le sillon S de l'oreille ORG, ORD sur une longueur comprise entre 2 et 2,5 centimètres (figure 6) et qu'elle se situe à une distance comprise entre 2 et 5 millimètres du crâne du porteur. On peut également prévoir que la forme de la spatule soit adaptée tout le long du sillon de l'oreille. Cet ajustage permet une meilleure tenue de l'équipement, notamment pour ceux ayant un nez assez plat, ayant une forte correction ou une activité dynamique importante.

On peut également prévoir de prendre en compte les souhaits spécifiques du porteur pour déterminer la déformation nécessaire de la monture en vue de réaliser un ajustage satisfaisant pour ce porteur.

A cet effet, il est possible de demander au porteur de remplir un questionnaire afin de déterminer s'il souhaite par exemple que la monture de lunettes s'appuie sur une partie haute du nez, proche de ses yeux, afin d'augmenter son champ de vision, ou s'il préfère que la monture s'appuie à proximité de l'extrémité basse de son nez. Il est également possible de se baser sur l'observation du porteur avec son ancienne monture de lunettes pour déterminer ses souhaits.

Ensuite, ses souhaits sont traduits en critères d'ajustage en se fondant sur les règles d'ajustage suivantes. Comme décrit ci-dessous, on ajuste notamment la distance entre les yeux du porteur et les cercles de la monture, ainsi que l'angle pantoscopique de celle-ci.

Pour ajuster le positionnement des cercles 11, 12 devant les yeux OD, OG et/ou limiter les zones de contact entre les cercles 11, 12 et les pommettes J ou les sourcils SC du porteur, il est possible de modifier l'écart entre les plaquettes 16A. Le nez ayant une forme trapézoïdale, plus l'écart entre les plaquettes 16A sera faible, plus la monture 10 se positionnera de manière haute sur le visage du porteur.

On peut également ajuster les bras 17 des plaquettes 16A pour éloigner ou rapprocher les plaquettes 16A des cercles 11, 12 de la monture 10 et ainsi modifier la distance entre les yeux OD, OG et les lentilles ophtalmiques qui seront portées par la monture 10.

Pour assurer l'horizontalité de la monture et ajuster l'angle pantoscopique, on peut modifier l'inclinaison des branches 14, 15 par rapport aux cercles 11, 12 de la monture 10. Cela permet également de régler le contact entre chaque branche 14, 15 et le sillon S de l'oreille ORD, ORG correspondante du porteur.

Pour assurer l'horizontalité de la monture 10 sur la tête TS du porteur par rapport aux sourcils ou par rapport aux yeux, il faut incliner vers le bas la branche du côté du cercle le plus bas ou incliner vers le haut la branche du côté du cercle le plus haut.

En fonction de la hauteur des oreilles ORD, ORG par rapport aux yeux, on peut incliner les branches 14, 15 vers le bas de la tête du porteur pour augmenter l'angle pantoscopique, ce qui favorise la vision de près du porteur ou incliner les branches 14, 15 pour diminuer l'angle pantoscopique, ce qui permet notamment de limiter le contact entre le bas des cercles de la monture et les pommettes.

L'ouverture des branches 14, 15 est initialement symétrique. Toutefois, si la façade de la monture 10, qui comprend les cercles 11, 12 et le pont 13, n'est pas parallèle au visage du porteur, on peut ajuster le parallélisme en ouvrant plus la branche 14, 15 du côté de la façade le plus éloigné du visage du porteur.

Lorsque les branches ne comportent pas de spatules, le matériau de la monture doit être assez rigide et l'ouverture des branches doit être déterminée précisément pour maintenir la monture sur la tête sans comprimer celle-ci.

Afin de déterminer la déformation nécessaire de la monture 10 pour réaliser l'ajustage, on peut tout d'abord identifier les zones d'interférences entre la modélisation de la monture 10 et la modélisation de la tête TS du porteur. Ces zones d'interférences correspondent par exemple aux régions de l'espace dans le deuxième référentiel O2X2Y2Z2 de la tête TS du porteur dans lesquelles la modélisation de la monture 10 et la modélisation de la tête TS du porteur pénètrent l'une à l'intérieur de l'autre. Une fois ces zones d'interférences identifiées, on détermine par le calcul la déformation de la modélisation de la monture 10 nécessaire afin de supprimer toutes les zones d'interférences. A cet effet, on autorise seulement un nombre limité de déformations de la monture, correspondant aux réglages possibles de cette monture 10 lors de l'ajustage :
- modification de l'angle d'inclinaison des branches de la monture par rapport aux cercles de la monture, c'est-à-dire dans le plan O1X1Z1,
- modification de l'angle d'inclinaison des spatules 14A, 15A par rapport à la première partie de la branche 14, 15 correspondante,
- modification de l'écartement des extrémités des deux branches,
- modification du galbe de la monture.

Pour les montures comportant des plaquettes 16A montés sur un bras 17 et non intégrés aux cercles, il est également possible de modifier la distance entre les surfaces de contact 16 des plaquettes et les cercles 11, 12 de la monture 10, ainsi que l'angle de face et l'ange de chasse de chaque plaquette 16A.

L'angle de chasse de chaque plaquette 16A correspond à l'inclinaison de la surface de contact de la plaquette par rapport au plan O1Y1Z1 de la monture 10, mesuré en projection dans le plan O1X1Z1.

L'angle de face de chaque plaquette 16A correspond à l'inclinaison de la surface de contact de la plaquette par rapport au plan O1Y1Z1, mesurée en projection dans le plan O1X1Y1.

Il est possible de prévoir des valeurs limites de déformation à ne pas dépasser au risque d'endommager la monture, qui peuvent dépendre du matériau de la monture.

Une fois les zones d'interférences éliminées, il est possible de continuer l'optimisation du placement de la monture 10 sur la tête du porteur en fonction des critères précédemment exposés, notamment en fonction de la valeur cible de la distance entre l'œil et la lentille, la valeur cible de l'angle pantoscopique, le galbe de la monture, la hauteur de la monture par rapport aux pommettes et aux sourcils du porteur.

Comme expliqué précédemment, le procédé est de préférence tout d'abord mis en oeuvre au moment du choix de la monture, avant la réalisation des lentilles ophtalmiques destinées à être montées dans cette monture.

Les moyens informatiques et électroniques peuvent alors être programmés pour déduire de la déformation nécessaire de la monture déterminée, un niveau de difficulté de l'ajustage. Ce niveau de difficulté est transmis à l'opérateur qui peut alors conseiller au porteur de choisir une autre monture si l'ajustage se révèle trop difficile.

L'expérience de l'opérateur et ses capacités à réaliser l'ajustage déterminé peuvent également être prises en compte.

Une alerte peut être émise si un ajustage satisfaisant est impossible, par exemple si l'ajustage nécessaire dépasse les limites mécaniques de la monture et risque de l'endommager, ou si le réglage souhaitable sur la monture n'est pas possible. Par exemple, il n'est pas possible de régler sur des montures plastiques l'écartement des plaquettes, car ces montures n'en possèdent pas.

Ainsi, selon l'invention revendiquée, les moyens informatiques et électroniques réalisent, à la suite de l'étape d), une étape additionnelle p) de renvoi d'information sur l'adéquation entre la capacité à se déformer de la monture et la déformation nécessaire de la monture 10 déterminée à l'étape d).

Les moyens informatiques et électroniques peuvent également être programmés pour déterminer, en fonction de la déformation nécessaire de la monture déterminée, une modélisation corrigée de la monture de lunettes après cette déformation et pour en déduire un paramètre de confort et de performance visuelle de la paire de lunettes comprenant cette monture. Ces paramètres peuvent être déterminés respectivement en prenant en compte le poids des lentilles ophtalmiques et le placement des yeux par rapport aux cercles de la monture de lunettes.

Ainsi, avantageusement, les moyens informatiques et électroniques peuvent réaliser, à la suite de l'étape d), une étape additionnelle q) de renvoi d'information indiquant une position relative finale prévue de la monture sur la tête du porteur, après ajustage, et éventuellement réajustage, de la monture.

Ces différentes informations sont transmises à l'opérateur et peuvent constituer une aide à la décision dans le choix de la monture de lunettes.

Lorsque le choix de la monture est définitif, le procédé permet alors notamment d'ajuster la monture au visage du porteur afin de prendre les mesures nécessaires à la fabrication des lentilles ophtalmiques sur le porteur portant la monture de lunettes ajustée. On peut ainsi mesurer la position des pupilles des deux yeux par rapport aux cercles de la monture et ainsi centrer correctement les lentilles ophtalmiques par rapport à la monture pour que leurs points de centrage soient en face des pupilles des yeux. Cela peut être réalisé physiquement, avec la monture 10 dans sa géométrie ajustée, ou numériquement.

Dans le premier cas, dans une étape f) du procédé, on applique à la monture 10 de lunettes la déformation déterminée à l'étape d). Puis on réalise les mesures nécessaires à la fabrication des lentilles ophtalmiques sur le porteur équipée de la monture de lunettes ajustée. Dans le deuxième cas, dans une étape g), on détermine la position relative corrigée du modèle d'une partie des cercles de la monture et du modèle d'une partie des yeux du porteur en prenant en compte la déformation nécessaire de la monture déterminée à l'étape d), au moyen d'une simulation numérique analogue à celle de l'étape c).

Dans une étape h), on détermine au moins un paramètre géométrico-physionomique d'implantation d'une lentille ophtalmique dans la monture pour que le centre optique de la lentille vienne en regard de l'œil correspondant du porteur, en fonction de ladite position relative corrigée déterminée à l'étape g).

Ces paramètres géométrico-physionomiques d'implantation comprennent par exemple notamment la hauteur H des pupilles par rapport au point le plus bas des cercles de la monture (figure 4), l'angle pantoscopique AMV, les demi écarts pupillaires et la position des centres de rotation des yeux.

Optionnellement, dans une étape i) on détermine au moins une caractéristique de réfraction optique d'au moins une lentille ophtalmique à monter dans cette monture 10 en fonction de ladite position relative corrigée déterminée à l'étape g).

La fabrication des lentilles ophtalmiques est alors plus précise, et adaptée à la fois au porteur et à la monture choisie.

Une fois les lentilles ophtalmiques fabriquées et montées dans la monture de lunettes, il est possible que le poids des lentilles ophtalmiques déforme la monture de lunettes et que celle-ci ne présente plus exactement la géométrie ajustée avant le montage des lentilles ophtalmique. Il est alors possible de réitérer le procédé selon l'invention afin de déterminer la déformation de la monture nécessaire pour ajuster la monture munie des lentilles ophtalmiques sur le visage du porteur. On parle alors de réajustage de la monture.

Ce réajustage peut par exemple prendre en compte un coefficient d'élasticité de la peau du nez et/ou un paramètre qui varie en fonction du poids des lentilles ophtalmiques.

Avantageusement, la modélisation du porteur étant en mémoire dans les moyens informatiques et électroniques, ce réajustage peut être effectué en l'absence du porteur.

Que ce soit pour l'ajustage ou le réajustage de la monture de lunettes, les moyens informatique et électroniques sont de plus de préférence programmés pour afficher des instructions permettant à l'opérateur d'appliquer étape par étape la déformation déterminée à l'étape d) pour la monture de lunettes.

On a décrit ici un exemple de réalisation du procédé selon lequel, aux étapes a) et b) les modélisations de la monture 10 de lunettes et de la tête TS du porteur sont des modélisations numériques, et, à l'étape c), la superposition des deux modélisations est réalisée par un calcul numérique.

Selon un deuxième mode de réalisation du procédé d'ajustage, à l'étape b) la modélisation de la tête TS du porteur est une modélisation physique, et, à l'étape c), on superpose sur cette modélisation physique de la tête TS du porteur, une modélisation physique de la monture (10), par le placement réel de la modélisation physique de la monture (10) de lunettes sur la modélisation physique de la tête du porteur.

Ainsi, on réalise, préalablement à l'étape b), une étape a) de détermination d'une modélisation physique de la monture de lunettes. Ceci présente l'avantage de permettre la détermination de la déformation nécessaire de la monture pour l'ajustage de cette monture sur la tête de l'individu, même sans disposer de la monture réelle, et sans moyens de traitement informatiques et électroniques particuliers permettant une modélisation numérique et une superposition par calcul.

Cette modélisation physique de la monture peut être réalisée par des techniques connues de prototypage, par exemple par impression 3D après une acquisition d'images de cette monture.

A l'étape d), on détermine, à partir de cette superposition, la déformation nécessaire de la monture 10 pour obtenir un ajustage de la monture 10 sur la tête TS du porteur conforme à au moins un critère d'ajustage prédéterminé.

Les critères d'ajustage pris en compte ici sont les mêmes que ceux décrits dans le premier mode de réalisation.

Il s'agit notamment des critères suivants :
- maximisation de la surface de contact 16 entre les plaquettes 16A du pont 13 et le nez du porteur,
- maximisation du contact entre les branches 14, 15 de la monture 10 et le sillon S des oreilles ORD, ORG du porteur,
- centrage des yeux OD, OG par rapport aux cercles 11, 12 de la monture 10. Du fait que l'on envisage des déformations possibles de la monture, il est possible de prendre en compte d'autres critères :
- maintien de l'axe O1X1 du premier référentiel de la monture parallèle à l'axe O2X2 du deuxième référentiel de la tête afin de garantir l'horizontalité de la monture 10,
- minimisation des zones de contact entre les cercles 11, 12 de la monture 10 et les pommettes J et/ou les sourcils SC du porteur.

Ces critères peuvent être évalués à l'œil par l'opérateur.

Il peut également s'agir d'atteindre une ou plusieurs valeurs cibles, tel que décrit dans le premier mode de réalisation.

L'opérateur peut à cet effet, prendre des mesures de distance ou d'angle sur la superposition de la modélisation de la monture et de la modélisation de la tête du porteur.

Dans tous les cas, l'opérateur évalue ainsi la déformation nécessaire de la monture.

Ensuite, cette déformation peut être appliquée à la monture réelle afin de réaliser l'ajustage.

Selon un troisième mode de réalisation du procédé d'ajustage selon l'invention, à l'étape b) la modélisation de la tête TS du porteur est une modélisation physique, et, à l'étape c), on superpose sur cette modélisation physique de la tête TS du porteur, la monture 10 elle-même, par le placement réel de cette monture 10 de lunettes sur la modélisation physique de la tête du porteur.

Dans ce cas, aucune étape de détermination d'une modélisation de la monture n'est réalisée. La monture de lunettes réelle est directement utilisée et placée sur la modélisation de la tête du porteur.

Cela présente l'avantage de permettre de réaliser un ajustage de la monture précis, même en l'absence du porteur. Cela pourrait par exemple permettre d'expédier la monture déjà ajustée au porteur.

De préférence, dans les deuxième et troisième modes de réalisation, à l'étape b), la modélisation physique de la tête est réalisée à l'échelle 1, en utilisant au moins l'une des techniques suivantes :
- techniques issues du prototypage rapide,
- banc déformable qui peut être motorisé ou non.

La modélisation de la tête du porteur peut comprendre une tête artificielle avec des modèles d'oreilles et de nez réglables, par exemple motorisés, pilotés par le dispositif informatique et électronique.

En variante, la modélisation physique de la tête est réalisée à partir d'un support déformable et d'un ensemble de pièces rapportées sur ce support.

Cette tête artificielle peut par exemple comporter un support déformable reproduisant la forme et les dimensions globales de la tête, qui reçoit des modèles d'oreilles et de nez réalisés par impression en trois dimensions des données enregistrées par une acquisition d'image en trois dimensions du porteur.

En variante encore, il est possible d'envisager que, à l'étape b), on sélectionne la modélisation physique de la tête parmi un ensemble de modélisations de tête réalisées au préalable.

Cette sélection est par exemple effectuée sur la base de critères de formes du visage, du nez et des oreilles.

Les critères d'ajustage pris en compte ici sont les mêmes que ceux décrits précédemment.

Ces critères peuvent être évalués à l'œil par l'opérateur ou à l'aide d'instruments de mesure. Dans tous les cas, l'opérateur évalue la déformation nécessaire de la monture.

Cette déformation peut être ici directement appliquée à la monture réelle afin de réaliser l'ajustage de la monture réelle sur la modélisation de la tête du porteur.

Quel que soit le mode de réalisation de l'invention, on peut prévoir une étape de contrôle de l'ajustage réalisé, au cours de laquelle le centrage des cercles de la monture par rapport aux yeux du porteur, l'angle pantoscopique de la monture, la distance entre les yeux et les cercles de la monture, le galbe de la monture, le positionnement des branches sur les oreilles sont comparés aux valeurs cibles, standard ou personnalisées de ces paramètres.

Dans les deuxième et troisième modes de réalisation, la modélisation physique de la tête du porteur peut être fournie pour réaliser cette étape de contrôle, simultanément avec la monture ajustée. Par exemple, la modélisation peut être fournie à l'opticien afin de lui permettre de vérifier l'ajustage réalisé ou elle peut être fournie au porteur afin qu'il réajuste lui-même sa monture ayant été déformée par l'usage. Cette modélisation physique facilite les opérations de réajustage.

Quel que soit le mode de réalisation considéré, il est avantageusement possible de réaliser chaque étape en des lieux différents. Il est notamment possible de réaliser l'étape b) sur un premier site et l'étape d) sur un deuxième site.

Le premier site est localisé dans un lieu quelconque accessible soit physiquement par le porteur, soit sur internet : il s'agit notamment du lieu de travail d'un opticien, d'un kiosque installé dans une galerie marchande, ou encore du site internet d'un opticien. Le deuxième site est situé par exemple chez un opticien ou dans un laboratoire de montage de lunettes.

## Revendications

1. Procédé d'ajustage d'une monture (10) de lunettes réelle prédéterminée et choisie par un porteur donné, pour son utilisation par ce porteur, comportant les étapes suivantes :
b) on détermine une modélisation numérique au moins partielle de la tête (TS) du porteur, avec, dans un même référentiel, au moins un modèle (MN) d'une partie du nez (N) et un modèle (MORD, MORG) d'une partie des oreilles (ORD, ORG),
c) on effectue une simulation du positionnement de ladite monture (10) de lunettes réelle prédéterminée sur la tête (TS) du porteur, avant déformation de cette monture de lunettes réelle prédéterminée, en superposant, sur la modélisation numérique de la tête (TS) du porteur, les zones correspondantes d'une modélisation numérique de la monture (10) de lunettes réelle prédéterminée, par un calcul numérique,
ladite modélisation numérique de la monture (10) de lunettes réelle prédéterminée étant déterminée dans une étape a) réalisée préalablement à l'étape c), avec, dans un même autre référentiel, au moins un modèle d'une partie du pont (13) de la monture (10) et un modèle d'une partie des branches (14, 15) de la monture (10),
d) on détermine, à partir de cette superposition, la déformation nécessaire de la monture (10) réelle prédéterminée pour obtenir un ajustage de cette monture (10) sur la tête (TS) du porteur conforme à au moins un critère d'ajustage prédéterminé,
p) on renvoie une information sur l'adéquation entre la capacité à se déformer de la monture et la déformation nécessaire de la monture déterminée à l'étape d).

2. Procédé d'ajustage selon la revendication 1, selon lequel, à l'étape p), une alerte est émise si la déformation nécessaire dépasse les limites mécaniques de la monture et risque de l'endommager.

3. Procédé d'ajustage selon l'une des revendications 1 et 2, selon lequel, à l'étape c), on superpose, d'une part, le modèle d'une partie du pont de la monture (10) et le modèle (MN) d'une partie du nez du porteur, et, d'autre part, le modèle d'une partie des branches de la monture (10) et le modèle (MORD, MORG) d'une partie des oreilles du porteur.

4. Procédé d'ajustage selon l'une des revendications précédentes, selon lequel, à l'étape d), ledit critère d'ajustage prédéterminé comprend une position relative souhaitée des branches (14, 15) de la monture (10) par rapport aux oreilles (ORD, ORG) du porteur.

5. Procédé d'ajustage selon l'une des revendications précédentes, selon lequel, à l'étape d), ledit critère d'ajustage prédéterminé comprend un écartement des branches (14, 15) de la monture (10) souhaité en fonction d'un écart déterminé entre les oreilles (ORD, ORG).

6. Procédé d'ajustage selon l'une des revendications précédentes, selon lequel, à l'étape d), ledit critère d'ajustage prédéterminé consiste en une optimisation de la surface de contact entre deux plaquettes (16A) du pont (13) de la monture (10) et du nez (N) du porteur.

7. Procédé d'ajustage selon l'une des revendications précédentes, selon lequel, à l'étape a), on détermine en outre un modèle d'une partie des cercles (11, 12) de la monture (10), à l'étape b), on détermine en outre un modèle (MOD, MOG) d'une partie des yeux (OD, OG) du porteur et à l'étape d), ledit critère d'ajustage prédéterminé comprend une position relative des cercles (11, 12) de la monture (10) et des yeux (OD, OG) du porteur.

8. Procédé d'ajustage selon l'une des revendications précédentes, selon lequel, à l'étape a), on détermine en outre un modèle d'une partie des cercles (11, 12) de la monture (10) ; à l'étape b), on détermine en outre un modèle d'une partie des pommettes (J) et/ou des sourcils (SC) du porteur, et à l'étape d), ledit critère d'ajustage prédéterminé comprend une distance minimale souhaitée entre les cercles (11, 12) de la monture (10) et les pommettes et/ou les sourcils du porteur.

9. Procédé d'ajustage selon la revendication 7, selon lequel on réalise en outre les étapes suivantes :
g) on détermine la position relative corrigée du modèle d'une partie des cercles (11, 12) de la monture (10) et du modèle d'une partie des yeux du porteur en prenant en compte la déformation nécessaire de la monture (10) déterminée à l'étape d), au moyen d'une simulation numérique analogue à celle de l'étape c), et,
i) on détermine au moins une caractéristique de réfraction optique d'au moins une lentille ophtalmique à monter dans cette monture (10) en fonction de ladite position relative corrigée déterminée à l'étape g).

10. Procédé d'ajustage selon l'une des revendications précédentes, selon lequel on réalise, à la suite de l'étape d), l'étape additionnelle suivante :
q) un renvoi d'information indiquant une position relative finale prévue de la monture sur la tête du porteur, après ajustage de la monture.

## Patentansprüche

1. Verfahren zur Anpassung einer vorbestimmten und von einem gegebenen Träger ausgewählten realen Brillenfassung (10) zur Verwendung durch diesen Träger, umfassend die folgenden Schritte:
b) Bestimmen einer zumindest partiellen digitalen Modellierung des Kopfes (TS) des Trägers mit zumindest einem Modell (MN) eines Teils der Nase (N) und einem Modell (MORD, MORG) eines Teils der Ohren (ORD, ORG) in demselben Bezugssystem,
c) Durchführen einer Simulation der Positionierung der vorbestimmten realen Brillenfassung (10) auf dem Kopf (TS) des Trägers vor der Verformung dieser vorbestimmten realen Brillenfassung durch Übereinanderlegen der digitalen Modellierung des Kopfes (TS) des Trägers und der entsprechenden Bereiche einer digitalen Modellierung der vorbestimmten realen Brillenfassung (10) durch eine numerische Berechnung, wobei die digitale Modellierung der vorbestimmten realen Brillenfassung (10) in einem vor dem Schritt c) durchgeführten Schritt a) mit einem gleichen anderen Bezugssystem mindestens eines Modells eines Teils des Stegs (13) der Fassung (10) und eines Modells eines Teils der Bügel (14, 15) der Fassung (10) bestimmt wird,
d) ausgehend von diesem Übereinanderlegen Bestimmen der erforderlichen Verformung der vorbestimmten realen Fassung (10), um eine Anpassung dieser Fassung (10) an den Kopf (TS) des Trägers gemäß mindestens einem vorbestimmten Anpassungskriterium zu erhalten,
p) Zurückgeben einer Information über die Entsprechung zwischen der Verformbarkeit der Fassung und der in Schritt d) bestimmten erforderlichen Verformung der Fassung.

2. Anpassungsverfahren nach Anspruch 1, wonach in Schritt p) eine Warnung ausgegeben wird, wenn die erforderliche Verformung die mechanischen Grenzen der Fassung überschreitet und sie beschädigen könnte.

3. Anpassungsverfahren nach einem der Ansprüche 1 und 2, wobei in Schritt c) einerseits das Modell eines Teils des Stegs der Fassung (10) und das Modell (MN) eines Teils der Nase des Trägers, und andererseits das Modell eines Teils der Bügel der Fassung (10) und das Modell (MORD, MORG) eines Teils der Ohren des Trägers übereinandergelegt werden.

4. Anpassungsverfahren nach einem der vorangehenden Ansprüche, wonach in Schritt d) das vorbestimmte Anpassungskriterium eine gewünschte relative Position der Bügel (14, 15) der Fassung (10) in Bezug auf die Ohren (ORD, ORG) des Trägers umfasst.

5. Anpassungsverfahren nach einem der vorangehenden Ansprüche, wonach in Schritt d) das vorbestimmte Anpassungskriterium einen gewünschten Abstand der Bügel (14, 15) der Fassung (10) in Abhängigkeit von einem bestimmten Abstand zwischen den Ohren (ORD, ORG) umfasst.

6. Anpassungsverfahren nach einem der vorangehenden Ansprüche, wonach in Schritt d) das Anpassungskriterium in einer Optimierung der Kontaktfläche zwischen zwei Plättchen (16A) des Stegs (13) der Fassung (10) und der Nase (N) des Trägers besteht.

7. Anpassungsverfahren nach einem der vorangehenden Ansprüche, wonach in Schritt a) ferner ein Modell eines Teils der Rahmen (11, 12) der Fassung (10) bestimmt wird, in Schritt b) ferner ein Modell (MOD, MOG) eines Teils der Augen (OD, OG) des Trägers bestimmt wird und in Schritt d), das vorbestimmte Anpassungskriterium eine relative Position der Rahmen (11, 12) der Fassung (10) und der Augen (OD, OG) des Trägers umfasst.

8. Anpassungsverfahren nach einem der vorangehenden Ansprüche, wonach in Schritt a) ferner ein Modell eines Teils der Rahmen (11, 12) der Fassung (10) bestimmt wird; in Schritt b), ferner ein Modell eines Teils der Wangenknochen (J) und/oder der Brauen (SC) des Trägers bestimmt wird und in Schritt d) das vorbestimmte Anpassungskriterium einen gewünschten Mindestabstand zwischen den Rahmen (11, 12) der Fassung (10) und den Wangenknochen und/oder den Brauen des Trägers umfasst.

9. Anpassungsverfahren nach Anspruch 7, wonach ferner die folgenden Schritte ausgeführt werden:
g) Bestimmen der korrigierten relativen Position des Modells eines Teils der Rahmen (11, 12) der Fassung (10) und des Modells eines Teils der Augen des Trägers unter Berücksichtigung der in Schritt d) bestimmten erforderlichen Verformung der Fassung (10) anhand einer numerischen Simulation analog zu Schritt c) und
i) Bestimmen mindestens eines optischen Brechungsmerkmals mindestens einer in diese Fassung (10) zu montierenden ophthalmischen Linse in Abhängigkeit von der in Schritt g) bestimmten korrigierten relativen Position.

10. Anpassungsverfahren nach einem der vorangehenden Ansprüche, wonach nach Schritt d) der folgende zusätzliche Schritt ausgeführt wird:
q) Zurückgeben einer Information, die eine vorgesehene endgültige relative Position der Fassung auf dem Kopf des Trägers nach Anpassung der Fassung angibt.

## Claims

1. Method for adjusting a predetermined real spectacle frame (10) chosen by a given wearer, for its use by this wearer, including the following steps:
b) determining an at least partial numerical model of the head (TS) of the wearer, with, in a given frame of reference, at least a model (MN) of one portion of the nose (N) and a model (MORD, MORG) of one portion of the ears (ORD, ORG),
c) simulating the positioning of said predetermined real spectacle frame (10) on the head (TS) of the wearer, before deformation of this predetermined real spectacle frame, by superposing, on the numerical model of the head (TS) of the wearer, the corresponding zones of a numerical model of the predetermined real spectacle frame (10), via a numerical calculation,
said numerical model of the predetermined real spectacle frame (10) being determined in a step a) carried out prior to step c), with, in a given other frame of reference, at least a model of one portion of the bridge (13) of the frame (10) and a model of one portion of the temples (14, 15) of the frame (10),
d) determining, from this superposition, the deformation of the predetermined real frame (10) required to obtain a fit of this frame (10) on the head (TS) of the wearer meeting at least one predetermined fitting criterion,
p) returning information on the compatibility between the deformability of the frame and the required deformation of the frame determined in step d).

2. Adjusting method according to Claim 1, wherein, in step p), an alarm is raised if the required deformation exceeds the mechanical limits of the frame and risks damaging it.

3. Adjusting method according to either of Claims 1 and 2, wherein, in step c), the following are superposed: on the one hand, the model of one portion of the bridge of the frame (10) and the model (MN) of one portion of the nose of the wearer, and on the other hand, the model of one portion of the temples of the frame (10) and the model (MORD, MORG) of one portion of the ears of the wearer.

4. Adjusting method according to one of the preceding claims, wherein, in step d), said predetermined fitting criterion comprises a desired relative position of the temples (14, 15) of the frame (10) with respect to the ears (ORD, ORG) of the wearer.

5. Adjusting method according to one of the preceding claims, wherein, in step d), said predetermined fitting criterion comprises a desired spacing of the temples (14, 15) of the frame (10), depending on a determined separation between the ears (ORD, ORG).

6. Adjusting method according to one of the preceding claims, wherein, in step d), said predetermined fitting criterion consists of an optimization of the area of contact between two pads (16A) of the bridge (13) of the frame (10) and the nose (N) of the wearer.

7. Adjusting method according to one of the preceding claims, wherein, in step a), a model of one portion of the rims (11, 12) of the frame (10) is moreover determined, in step b), a model (MOD, MOG) of one portion of the eyes (OD, OG) of the wearer is moreover determined and, in step d), said predetermined fitting criterion comprises a relative position of the rims (11, 12) of the frame (10) and of the eyes (OD, OG) of the wearer.

8. Adjusting method according to one of the preceding claims, wherein, in step a), a model of one portion of the rims (11, 12) of the frame (10) is moreover determined, in step b), a model of one portion of the cheekbones (J) and/or eyebrows (SC) of the wearer is moreover determined and, in step d), said predetermined fitting criterion comprises a desired minimum distance between the rims (11, 12) of the frame (10) and the cheekbones and/or eyebrows of the wearer.

9. Adjusting method according to Claim 7, wherein, the following steps are moreover carried out:
g) the corrected relative position of the model of one portion of the rims (11, 12) of the frame (10) and of the model of one portion of the eyes of the wearer is determined, while taking into account the required deformation of the frame (10) determined in step d), by means of a numerical simulation analogous to that of step c), and
i) depending on said corrected relative position determined in step g), at least one optical refraction characteristic of at least one ophthalmic lens to be mounted in this frame (10) is determined.

10. Adjusting method according to one of the preceding claims, wherein, following step d), the following additional step is carried out:
q) returning information indicating an anticipated final relative position of the frame on the head of the wearer, after the frame has been adjusted.
